Europäisches Patentamt

European Patent Office

Office européen des brevets

(19)

(11) EP 0 556 077 B1

(12) FASCICULE DE BREVET EUROPEEN

(45) Date de publication et mention
de la délivrance du brevet:
27.11.1996 Bulletin 1996/48

(51) Int Cl.6: H03F 3/50

(21) Numéro de dépôt: 93400151.2

(22) Date de dépôt: 22.01.1993

(54) **Amplificateur à transistor suiveur**

Transistorfolgeverstärker

Transistor follower amplifier

(84) Etats contractants désignés:
DE FR GB IT NL

(30) Priorité: 31.01.1992 FR 9201091

(43) Date de publication de la demande:
18.08.1993 Bulletin 1993/33

(73) Titulaire: THOMSON-CSF SEMICONDUCTEURS
SPECIFIQUES
F-92800 Puteaux (FR)

(72) Inventeur: Grasset, Jean-Charles
F-92402 Courbevoie Cedex (FR)

(74) Mandataire: Guérin, Michel et al
THOMSON-CSF
SCPI
B.P. 329
50, rue Jean-Pierre Timbaud
92402 Courbevoie Cédex (FR)

(56) Documents cités:
EP-A- 0 463 857          DE-A- 2 509 013

# Description

L'invention concerne les circuits du type émetteur suiveur également appelé "transistor en collecteur commun", notamment ceux réalisés en circuits intégrés bipolaires. Elle concerne particulièrement des moyens pour la polarisation des émetteurs suiveurs.

L'emploi d'un transistor bipolaire monté en "suiveur" (ou "collecteur commun") est d'un usage très répandu, particulièrement en électronique analogique. Ses principales caractéristiques sont un gain en tension proche de l'unité, et un gain en courant important égal à $\underline{B}+1$ ; $\underline{B}$ étant le gain du transistor égal à IC/IB (IC est le courant collecteur, IB est le courant base). Le signal à traiter ou signal d'entrée est appliqué sur la base du transistor et le signal de sortie correspondant est délivré sur l'émetteur. Les variations de la tension de sortie VS sur l'émetteur représentent le signal d'entrée avec un gain proche de 1. L'avantage d'un tel montage est notamment que le signal de sortie peut être obtenu avec un fort courant. Son l'utilisation pose parfois des difficultés, notamment lorsque l'on cherche à conférer un courant émetteur de repos relativement important (souvent pour des contraintes de vitesse), ce qui conduit à imposer un courant base de polarisation lui-même relativement important.

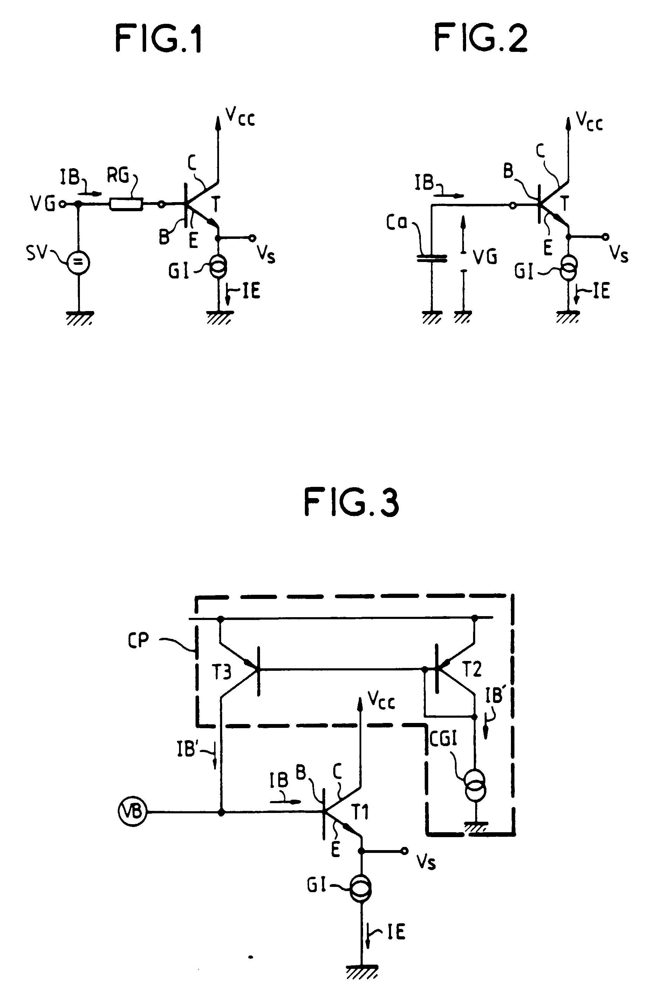

Les figures 1 et 2 illustrent par des configurations classiques deux cas où la tension "lue" sur la base du transistor suiveur, est entachée d'erreur à cause du courant de base IB non nul.

La figure 1 illustre le cas d'un signal en tension VG appliqué à la base B d'un transistor T. Le signal en tension VG est délivré par une source de tension SV. Le signal de sortie VS correspondant est délivré par l'émetteur E du transistor T. L'émetteur E est relié au potentiel de la masse par l'intermédiaire d'un générateur de courant GI, dans lequel circule le courant émetteur IE du transistor T. Le collecteur C du transistor T est relié à un potentiel d'alimentation VCC positif par rapport à la masse.

Le courant base IB produit une chute de tension dans la résistance interne RG de la source SV, de telle sorte que la tension VB lue sur la base B est égale à VG - RG.IB.

La figure 2 illustre un autre cas dans lequel une capacité Ca est disposée entre la base du transistor suiveur T et la masse. Le transistor T est relié d'une même manière que dans l'exemple précédent en ce qui concerne son collecteur C et son émetteur E. Ceci représente une configuration courante des transistors suiveurs utilisés pour la lecture des échantillonneurs-bloqueurs. Dans une telle configuration, la capacité Ca est chargée par une impulsion à une tension VG, tension qui décroît avec le temps du fait de la décharge de la capacité Ca par le courant base IB. On parle de taux de décroissance de la tension en fonction du temps ("droprate" en anglais).

En vue d'éviter les inconvénients liés à la présence du courant base de polarisation, il est connu d'associer au transistor suiveur un circuit de polarisation qui injecte dans la base de ce dernier un courant additionnel. Ce courant additionnel constitue le courant base de polarisation qui ainsi n'est pas prélevé sur le signal appliqué au transistor suiveur.

Il est à noter que les inconvénients illustrés en référence aux figures 1 et 2, dus au courant de polarisation dans la base, existent également dans le cas de transistors du type PNP.

La figure 3 montre le schéma d'une configuration classique associant un transistor suiveur T1 à un tel circuit de polarisation CP.

Comme dans l'exemple des figures 1 et 2, le collecteur C du transistor suiveur T1 est relié à un premier potentiel délivré par une source de tension à faible résistance interne, premier potentiel qui dans l'exemple est un potentiel positif d'alimentation VCC. Son émetteur E est relié à un second potentiel représenté par la masse, par l'intermédiaire d'un générateur de courant GI. Les variations de la tension VB sur la base B du transistor suiveur T1 se retrouvent sur la tension de sortie VS prélevée sur l'émetteur E.

Le générateur de courant GI impose au transistor suiveur T1 un courant émetteur IE ayant la valeur désirée, et auquel correspond un courant base IB injecté par le circuit de polarisation CP.

Le circuit de polarisation CP comprend deux transistors T2, T3 montés en miroir de courant, ainsi qu'un circuit générateur de courant CGI. Le circuit générateur de courant impose au transistor T2 un courant collecteur qui constitue une réplique IB' du courant de base IB du transistor suiveur T1.

Ce courant de réplique est recopié par le transistor T3, et injecté dans la base B du transistor suiveur.

Ceci constitue un montage du type en boucle ouverte dont la mise en oeuvre est relativement simple, et dans lequel on utilise, pour la réplique IB', un transistor polarisé dans des conditions identiques (ou presque) à celles du transistor suiveur à compenser. D'autres montages sont également utilisés, mais dont la mise en oeuvre est plus complexe, et dans lesquels on réalise une boucle (fermée) de contre-réaction qui compare en permanence le courant base réel et le courant de réplique pour les égaler.

Ces différents montages ont en commun qu'ils utilisent des transistors du type opposé à celui du transistor suiveur à polariser, pour réaliser le courant base IB à injecter dans ce dernier : par exemple dans l'exemple de la figure 3, le transistor suiveur T1 est du type NPN alors que T2, T3 sont du type PNP. Ceci constitue un premier inconvénient lorsque l'on n'a à sa disposition qu'un processus à un seul type de transistor. Il faut rappeler, en effet, qu'en règle générale, réaliser à la fois des transistors PNP et NPN dans un même processus, entraîne un accroissement de complexité de fabrication et donc de coût (surtout si les 2 types doivent être appairés en vitesse). Un autre inconvénient lié aux types de montages de polarisation précédemment décrits, est qu'ils présentent sur l'entrée une capacité parasite de collecteur qui détériore la caractéristique d'impédance d'entrée du montage.

La présente invention concerne tout montage (appelé amplificateur dans la suite de la description) dans lequel est utilisé au moins un transistor monté en "suiveur", associé à un circuit de polarisation en vue d'injecter dans la base du transistor suiveur le courant base de polarisation.

L'invention propose une architecture nouvelle qui évite les inconvénients ci-dessus cités, et qui notamment permet de réaliser la réplique du courant de base de polarisation et d'injecter ce courant, en utilisant des transistors bipolaires d'un même type que celui du transistor suiveur.

Suivant l'invention, un amplificateur comportant un transistor dit transistor suiveur, ayant son collecteur porté à un premier potentiel d'alimentation et son émetteur relié à un second potentiel d'alimentation par l'intermédiaire d'un générateur de courant, le transistor suiveur étant polarisé à l'aide d'un circuit de polarisation, est caractérisé en ce que le circuit de polarisation comporte d'une part, un transistor appelé transistor image dont le courant d'émetteur dit courant image est une réplique du courant d'émetteur dit courant émetteur de polarisation du transistor suiveur, le courant émetteur de polarisation et le courant image passant par le générateur de courant, et en ce qu'il comporte d'autre part des moyens pour injecter dans la base du transistor suiveur un courant constituant une réplique du courant base du transistor image.

Par les termes "premier et second potentiels d'alimentation" nous entendons définir tous potentiels délivrés par des sources de tension comportant une faible résistance interne, comme c'est le cas par exemple des potentiels d'alimentation (par exemple VCC pour une polarité positive et la masse pour une polarité négative de la tension d'alimentation).

En outre, par l'expression "une réplique du courant .... " il faut comprendre un courant dont la valeur est homothétique de celle dont il est une réplique, c'est-à-dire que les deux courants sont liés par un rapport connu, fonction notamment du rapport de géométrie entre les deux transistors : couramment les deux courants ont une même valeur quand les transistors de même type ont une même géométrie.

L'invention sera mieux comprise à la lecture de la description qui suit, faite à titre d'exemple non limitatif en référence aux dessins annexés, par lesquels :

- les figures 1 et 2 déjà décrites illustrent le fonctionnement d'un transistor monté en "suiveur" ;
- la figure 3 est un schéma montrant un transistor suiveur polarisé suivant l'art antérieur ;
- la figure 4 est un schéma montrant un amplificateur formé par un transistor suiveur associé à un circuit de polarisation conformément à l'invention ;

- la figure 5 illustre une forme de réalisation préférée d'un amplificateur suivant l'invention.

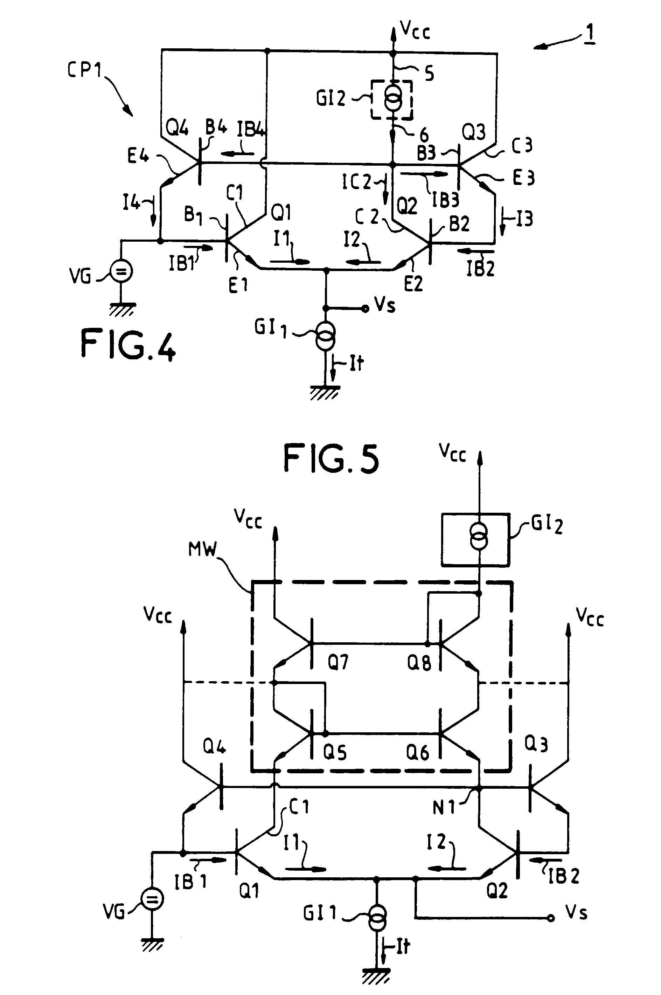

La figure 4 représente un amplificateur 1 comportant un transistor bipolaire Q1 formant un transistor suiveur ayant des fonctions semblables à celles expliquées dans le préambule. Dans l'exemple non limitatif décrit, le transistor suiveur Q1 est du type NPN, et par conséquent son collecteur C1 est porté à un potentiel positif par rapport au potentiel auquel est porté son émetteur E1. Dans l'exemple d'une part, l'émetteur E1 est relié à un générateur de courant $GI_1$ lui-même relié à la masse, et d'autre part le collecteur C1 est directement relié à un potentiel d'alimentation positif VCC.

La base B1 du transistor suiveur Q1 reçoit de façon classique un signal d'entrée provenant d'une source VG, et elle est reliée en outre à un circuit de polarisation $CP_1$ dont elle reçoit un courant $I_4$ qui constitue son courant base de polarisation $IB_1$.

Suivant une caractéristique de l'invention, d'une part le circuit de polarisation CP1 comporte un transistor Q2 appelé transistor image, d'un même type que le transistor suiveur Q1, à savoir NPN dans l'exemple, dont le courant d'émetteur I2 appelé courant émetteur image est une réplique du courant d'émetteur I1 du transistor suiveur Q1, courant qui est appelé courant émetteur de polarisation ; et d'autre part, le générateur de courant $GI_1$ impose un courant dit total It dont la valeur est égale à la somme $(IE_1 + IE_2)$ du courant émetteur de polarisation I1 et du courant image I2. En outre, suivant une autre caractéristique de l'invention, le courant de polarisation I4 injecté dans la base $B_1$ du transistor suiveur Q1, constitue une réplique du courant base $IB_2$ du transistor image Q2.

Dans l'exemple non limitatif décrit, les deux courants émetteurs, de polarisation I1 et image I2 et par conséquent les deux courants base $IB_1$, $IB_2$ sont identiques, le transistor suiveur Q1 et le transistor image Q2 étant appairés et ayant en outre de façon en elle-même classique, une même géométrie.

Le courant image I2, plus précisément le courant collecteur $IC_2$ du transistor image Q2 est imposé par un second dispositif générateur de courant $GI_2$, fonction qui de façon plus générale peut être remplie par une charge active. Dans l'exemple non limitatif de la figure 4, une première extrémité 5 du second générateur de courant ou charge active $GI_2$ est reliée au premier potentiel d'alimentation VCC (positif), et son extrémité 6 opposée est reliée à la fois au collecteur C2 du transistor image Q2, à la base B3 d'un troisième transistor Q3 et à la base B4 d'un quatrième transistor Q4. Tous ces transistors Q2, Q3, Q4 sont d'un même type que le transistor suiveur Q1, à savoir NPN dans l'exemple.

Le troisième transistor Q3 a son collecteur C3 relié au potentiel d'alimentation positif VCC, et il a son émetteur E3 relié à la base B2 du transistor image Q2. Le courant émetteur I3 du troisième transistor Q3 est constitué par le courant base $IB_2$ du transistor image Q2.

Le quatrième transistor Q4 a son émetteur E4 relié à la base B1 du transistor suiveur Q1, et son collecteur est porté au potentiel positif d'alimentation VCC.

Les troisième et quatrième transistors Q3 et Q4 sont appairés et ont une même géométrie, de telle sorte que le courant I4 du quatrième transistor Q4 recopie le courant du troisième transistor Q3, c'est-à-dire la valeur $I2/(\underline{B} + 1)$, $\underline{B}$ étant le gain du transistor image Q2. Comme $I1 = I2$, on a $I4 = I1/(\underline{B} + 1)$, c'est-à-dire la valeur désirée pour annuler le courant de base de Q1.

Concernant la boucle formée par les quatre transistors Q1, Q2, Q3 et Q4, on peut écrire (en supposant que ces quatre transistors ont un même courant de saturation) :

$$VBE4 + VBE1 - VBE2 - VBE3 = 0,$$

soit $(I4.I1) / (I2.I3) = 1$, où VBE4, VBE3, VBE2 et VBE1 sont respectivement les tensions base-émetteur des quatrième, troisième, second et premier transistors Q4, Q3, Q2, Q1.

On peut en déduire :

$$I4 = I2.I3/I1 = I1/(\underline{B} + 1), \text{ car } I3 = I2/ (\underline{B} + 1),$$

et $I2 = I1$ ; I4, I3, I2 et I1 correspondant respectivement au courant émetteur de Q4, Q3, Q2 et Q1.

Dans l'exemple des explications données ci-dessus où les courants émetteurs I1 et I2 de polarisation et image ont une même valeur, le premier générateur de courant $GI_1$ (relié aux deux émetteurs E1, E2) impose un courant total $I_t$ double du courant $IC_2$ qui est imposé par le moyen servant à constituer le second générateur de courant $GI_2$. En fait, le second générateur de courant $GI_2$ définit un courant $IC_2$ dans la branche image qui contient le transistor image Q2, et le premier générateur de courant $GI_1$ définit le courant total $I_t$ ($I_t$ étant égal à $IC_1 + IC_2$, aux courants base près des transistors Q1 et Q2) dans un tronçon commun à la branche image et à la branche contenant le transistor suiveur Q1 ($IC_1$ étant le courant collecteur de Q1).

Il est possible également de réaliser la configuration générale de la figure 3 avec des courants émetteurs I1, I2 dans un rapport n, $(I2/I1 = n)$ à condition d'ajuster en conséquence, les courants imposés par les générateurs de courant GI1, GI2, et les géométries des transistors Q2 et Q3 dans un rapport n avec celles unitaires de Q1 et Q4.

La précision de la compensation dépend entre autres des différences dans les conditions de polarisation des transistors Q1 à Q4, plus précisément d'une part, les différences de polarisation (courant émetteur, tension collecteur-émetteur) présentées entre le transistor suiveur Q1 et le transistor image Q2, et d'autre part les différences de polarisation entre les troisième et quatrième transistors Q3, Q4, ainsi que des erreurs aléatoires d'offset des transistors.

Bien entendu, le schéma montré à la figure 4 utilisant des transistors Q1 à Q4 tous d'un même type (NPN dans l'exemple), est transposable sans problème à une configuration avec des transistors tous du type PNP.

La configuration de l'invention présente comme avantage important, par rapport à l'art antérieur, de réaliser un circuit de compensation de polarisation CP qui n'exige pas dans tous les cas d'utiliser des transistors type PNP, compte tenu des nombreux défauts de ces derniers dans les procédés classique (PNP latéral).

Mais la solution de l'invention est intéressante aussi par le fait qu'elle n'utilise qu'un seul type de transistor, notamment un émetteur de transistor pour injecter le courant base de polarisation du transistor suiveur, ce qui ramène très peu de capacité parasite sur l'entrée du montage.

La figure 5 est un schéma montrant une forme de réalisation préférée d'un amplificateur 10 conforme à l'invention.

Le transistor suiveur Q1, le transistor image Q2, les troisième et quatrième transistors Q3, Q4, ainsi que le premier générateur de courant $GI_1$, sont dans une même configuration générale que celle illustrée à la figure 4, et fonctionnent d'une façon semblabe.

Cependant par rapport à la version de la figure 4, la version de la figure 5 est différente en ce que le circuit de polarisation CP 10 comporte en plus un circuit MW du type "miroir Wilson" en lui-même bien connu. Le circuit "miroir Wilson" MW permet de faire travailler le transistor suiveur Q1 et le transistor image Q2 dans les mêmes conditions de tension collecteur émetteur (VCE), sans déséquilibre sensible des courants de collecteurs IC1 et IC2. En conséquence, l'erreur de décalage des courants de collecteurs IC1 et IC2 devient de l'ordre de $1/\underline{B}^2$, alors que cette erreur est de l'ordre de $1/\underline{B}$ dans le cas de la figure 4.

A cette fin, d'une part le moyen $GI_2$ d'imposer le courant collecteur $IC_2$ du transistor image Q2 (moyen constitué par exemple par une charge active) et d'autre part le premier potentiel VCC, sont reliés respectivement au collecteur C2 du transistor image Q2 et au collecteur C1 du transistor suiveur Q1 par l'intermédiaire du miroir de Wilson MW.

Le miroir Wilson MW comporte de manière classique quatre transistors appelés cinquième, sixième, septième et huitième transistors Q5, Q6, Q7, Q8.

La charge active $GI_2$ est reliée par une extrémité au potentiel d'alimentation VCC, et par son autre extrémité elle est reliée à la fois au collecteur et à la base du huitième transistor Q8 (le huitième transistor étant monté en diode), ainsi qu'à la base du septième transistor Q7. L'émetteur du huitième transistor Q8 est relié au collecteur du sixième transistor Q6.

Le collecteur du septième transistor Q7 est relié au premier potentiel VCC, et l'émetteur de ce septième transistor est relié à la fois au collecteur et à la base du cinquième transistor Q5 (ce dernier étant monté en diode) ainsi qu'à la base du sixième transistor Q6.

Enfin, l'émetteur du cinquième transistor Q5 est relié au collecteur du transistor suiveur Q1, et l'émetteur du sixième transistor Q6 est relié au noeud N1 formé par le point où sont réunis le collecteur du transistor image Q2 et les bases des troisième et quatrième transistors Q3, Q4.

Il est possible en outre, de réduire l'erreur de polarisation des courants d'émetteurs I1, I2 due au courant de base $IB_I$, $IB_2$ des transistors suiveur et image Q1, Q2, à un ordre de grandeur négligeable ($1/\underline{B}^2$ au lieu de $1/\underline{B}$, $\underline{B}$ étant le gain en courant des transistors), en reliant les collecteurs des troisième et quatrième transistors Q3, Q4 respectivement à l'émetteur du septième transistor Q7 et à l'émetteur du huitième transistor Q8, comme représenté sur la figure 5 par des connexions en traits pointillés, au lieu de les raccorder directement au potentiel d'alimentation VCC ; ceci permet en outre de conserver l'égalité des tensions collecteur émetteur (VCE) des troisième et quatrième transistors Q3, Q4.

Il est à noter que l'invention peut s'appliquer quelle que soit la nature de la ou des charges actives utilisées, et qu'elle se prête particulièrement bien, quand on ne dispose pas de transistors PNP, à utiliser une charge active à réaction (tout NPN) qui possède par ailleurs des caractéristiques de vitesse intéressantes.

Des essais d'un circuit semblable à celui de la figure 5 (utilisant une technologie bipolaire NPN rapide) ont été effectués, en conférant :

- à la tension entre masse et VCC une valeur de 10 volts ;
- au courant total $I_t$ dans le premier générateur de courant $GI_1$, une valeur de 200 μA ;
- au courant $IC_2$ dans la charge active une valeur de 100 μA ;
- d'où un courant base $IB_1$ de polarisation dans le transistor suiveur Q1 de ordre de 746 nA (746 $10^{-9}$ A). Dans ces conditions, avec un courant IE d'entrée prélevé sur un signal d'entrée appliqué à l'entrée du suiveur Q1, c'est-à-dire à la base B1, de l'ordre de 5 nA, vu du signal d'entrée on a l'équivalent d'une division par 150 du courant de base.

**Revendications**

1. Dispositif amplificateur comportant, un transistor dit transistor suiveur (Q1) ayant son collecteur (C1) porté au premier potentiel d'alimentation (VCC), et son émetteur (E1) relié à un second potentiel d'alimentation (masse) par l'intermédiaire d'un générateur de courant ($GI_1$), le transistor suiveur (Q1) délivrant sur son émetteur (E1) un signal de sortie (VS) correspondant à un signal d'entrée appliqué à sa base (B1), le transistor suiveur (Q1) étant polarisé à l'aide d'un circuit de polarisation (CP1), caractérisé en ce que le circuit de polarisation comporte d'une part, un transistor appelé transistor image (Q2) dont le courant d'émetteur (I2) dit courant image est une réplique du courant d'émetteur (I1) dit courant émetteur de polarisation du transistor suiveur (Q1), le courant émetteur de polarisation et le courant image (I1, I2) passant par le générateur de courant ($GI_1$), et en ce qu'il comporte d'autre part les moyens (Q3, Q4) pour injecter dans la base (B1) du transistor suiveur un courant constituant une réplique du courant base du transistor image.

2. Dispositif amplificateur suivant la revendication 1, caractérisé en ce que le transistor image (Q2) est d'un même type (NPN) que le transistor suiveur (Q1).

3. Dispositif amplificateur suivant la revendication 2, caractérisé en ce que les émetteurs (E1, E2) du transistor suiveur (Q1) et du transistor image (Q2) sont réunis.

4. Dispositif amplificateur suivant l'une des revendications précédentes, caractérisé en ce que le transistor image (Q2) et le transistor suiveur (Q1) sont appairés.

5. Dispositif amplificateur suivant l'une des revendications précédentes, caractérisé en ce que le circuit de polarisation (CP1) comporte en outre des seconds moyens ($GI_2$) pour imposer au transistor image (Q2) un courant émetteur (I2) dont la valeur correspond à la différence (I2 = It-I1) entre un courant total (It) imposé par le générateur de courant ($GI_1$) et le courant émetteur de polarisation (I1) du transistor suiveur (Q2).

6. Dispositif amplificateur suivant l'une des revendications précédentes, caractérisé en ce que le courant émetteur de polarisation (I1) et le courant image (I2) ont une même valeur.

7. Dispositif amplificateur suivant l'une des revendications précédentes, caractérisé en ce qu'Il comporte un troisième et un quatrième transistor (Q3, Q4) montés en collecteur commun et dont les bases (B3, B4) sont reliées au collecteur (C2) du transistor image (Q2), l'émetteur (E3) du troisième transistor (Q3) étant relié à la base (B2) du transistor image (Q2) et l'émetteur (E4) du quatrième transistor (Q4) étant relié à la base (B1) du transistor suiveur (Q1).

8. Dispositif amplificateur suivant la revendication 7, caractérisé en ce que le transistor image (Q2) et les troisième et quatrième transistor (Q3, Q4) sont d'un même type (NPN) que le transistor suiveur (Q1).

9. Dispositif amplificateur suivant l'une quelconque des revendications 7 ou 8, caractérisé en ce que le troisième et le quatrième transistor (Q3, Q4) sont appairés.

10. Dispositif amplificateur suivant l'une quelconque des revendications 7 ou 8 ou 9, caractérisé en ce que le transistor suiveur (Q1), le transistor image (Q2) et les troisième et quatrième transistor (Q3, Q4) sont tous du type NPN.

11. Dispositif amplificateur suivant l'une des revendications précédentes, caractérisé en ce que le circuit de polarisation (CP1) comporte en outre un circuit du type "miroir de Wilson" (MW).

12. Dispositif amplificateur suivant l'une quelconque des revendications 5 à 10, caractérisé en ce que le circuit de polarisation (CP1) comporte un circuit du type "miroir Wilson" (MW) à l'aide duquel le transistor image (Q2) est relié aux seconds moyens (GI$_2$) pour imposer un courant émetteur (I2).

13. Dispositif amplificateur suivant l'une quelconque des revendications 5 à 12, caractérisé en ce que les second moyens (GI$_2$) pour imposer un courant émetteur au transistor image (Q2) sont constitués par une charge active.

**Patentansprüche**

1. Verstärkervorrichtung mit einem Transistor (Q1) in Emitterfolgeschaltung, dessen Kollektor (C1) am ersten Speisepotential (VCC) und dessen Emitter (E1) über einen Stromgenerator (GI$_1$) an einem zweiten Speisepotential (Masse) liegt und der an seinem Emitter (EI) ein Ausgangssignal (VS) entsprechend einem an seine Basis (B1) angelegten Eingangssignal liefert sowie mit Hilfe einer Polarisationsschaltung (CP1) polarisiert ist, dadurch gekennzeichnet, daß die Polarisationsschaltung einerseits einen Bildtransistor (Q2), dessen Emitterstrom (I2) ein Spiegelbild des Emitterstroms (I1), auch Polarisationsstrom genannt, des Folgetransistors (Q1) ist, wobei der Polarisationsstrom (I1) und der Bildstrom (I2) durch den Stromgenerator (GI$_1$) fließen, und andererseits Mittel (Q3, Q4) aufweist, die in die Basis (B1) des Folgetransistors einen Strom einspeisen, der ein Spiegelbild des Basisstroms des Bildtransistors ist.

2. Verstärkervorrichtung nach Anspruch 1, dadurch gekennzeichnet, daß der Bildtransistor (Q2) den gleichen Leitfähigkeitstyp (NPN) wie der Folgetransistor (Q1) besitzt.

3. Verstärkervorrichtung nach Anspruch 2, dadurch gekennzeichnet, daß die Emitter (E1, E2) des Folgetransistors (Q1) und des Bildtransistors (Q2) miteinander verbunden sind.

4. Verstärkervorrichtung nach einem der vorhergehenden Ansprüche, dadurch gekennzeichnet, daß der Bildtransistor (Q2) und der Folgetransistor (Q1) paarweise ausgesucht sind.

5. Verstärkervorrichtung nach einem der vorhergehenden Ansprüche, dadurch gekennzeichnet, daß die Polarisationsschaltung (CP1) außerdem zweite Mittel (GI$_2$) aufweist, die dem Bildtransistor (Q2) einen Emitterstrom (I2) aufprägen, dessen Wert der Differenz (I2 = I$_t$ - I1) zwischen einem Gesamtstrom (I$_t$), der vom Stromgenerator (GI$_1$) vorgegeben wird, und dem Polarisationsstrom (I1) am Emitter des Folgetransistors (Q2) entspricht.

6. Verstärkervorrichtung nach einem der vorhergehenden Ansprüche, dadurch gekennzeichnet, daß der Polarisationsstrom (I1) und der Bildstrom (I2) gleiche Werte besitzen.

7. Verstärkervorrichtung nach einem der vorhergehenden Ansprüche, dadurch gekennzeichnet, daß sie einen dritten und einen vierten Transistor (Q3, Q4) in Emitterfolgeschaltung aufweist, deren Basiselektroden (B3, B4) an den Kollektor (C2) des Bildtransistors (Q2) angeschlossen sind, und daß der Emitter (E3) des dritten Transistors (Q3) mit der Basis (B2) des Bildtransistors (Q2) und der Emitter (E4) des vierten Transistors (Q4) mit der Basis (B1) des Folgetransistors (Q1) verbunden sind.

8. Verstärkervorrichtung nach Anspruch 7, dadurch gekennzeichnet, daß der Bildtransistor (Q2) und der dritte und der vierte Transistor (Q3, Q4) den gleichen Leitfähigkeitstyp (NPN) wie der Folgetransistor (Q1) besitzen.

9. Verstärkervorrichtung nach einem beliebigen der Ansprüche 7 oder 8, dadurch gekennzeichnet, daß der dritte und der vierte Transistor (Q3, Q4) paarweise ausgesucht sind.

10. Verstärkervorrichtung nach einem beliebigen der Ansprüche 7, 8 und 9, dadurch gekennzeichnet, daß der Folgetransistor (Q1), der Bildtransistor (Q2) und der dritte sowie vierte Transistor (Q3, Q4) alle vom Leitfähigkeitstyp NPN sind.

11. Verstärkervorrichtung nach einem der vorhergehenden Ansprüche, dadurch gekennzeichnet, daß die Polarisationsschaltung (CP1) außerdem eine Schaltung vom Typ "Wilsonspiegel" (MW) besitzt.

12. Verstärkervorrichtung nach einem beliebigen der Ansprüche 5 bis 10, dadurch gekennzeichnet, daß die Polarisationsschaltung (CP1) eine Schaltung vom Typ "Wilsonspiegel" (MW) besitzt, über die der Bildtransistor (Q2) an die zweiten Mittel (GI$_2$) zum Aufprägen eines Emitterstroms (I2) angeschlossen ist.

13. Verstärkervorrichtung nach einem beliebigen der Ansprüche 5 bis 12, dadurch gekennzeichnet, daß die zweiten Mittel (GI$_2$), die dem Bildtransistor (Q2) einen Emitterstrom aufprägen, von einer aktiven Last gebildet werden.

**Claims**

1. Amplifier device including a transistor called a follower transistor (Q1) having its collector (C1) taken to the first power supply potential (VCC), and its emitter (E1) linked to a second power supply potential (earth) via a current generator (GI$_1$), the follower transistor (Q1), delivering on its emitter (E1) an output signal (VS) corresponding to an input signal applied to its base (B1), the follower transistor (Q1) being biased by the use of a bias circuit (CP1), characterized in that the bias circuit includes, on the one hand, a transistor called an image transistor (Q2) the emitter current (I2) of which, called image current, is a replica of the emitter current (I1), called emitter bias current, of the follower transistor (Q1), the emitter bias current and the image current (I1, I2) passing through the current generator (GI$_1$), and in that it includes, on the other hand, means (Q3, Q4) for injecting into the base (B1) of the follower transistor a current constituting a replica of the base current of the image transistor.

2. Amplifier device according to Claim 1, characterized in that the image transistor (Q2) is of the same type (NPN) as the follower transistor (Q1).

3. Amplifier device according to Claim 2, characterized in that the emitters (E1, E2) of the follower transistor (Q1) and of the image transistor (Q2) are joined together.

4. Amplifier device according to one of the preceding claims, characterized in that the image transistor (Q2) and the follower transistor (Q1) are paired.

5. Amplifier device according to one of the preceding claims, characterized in that the bias circuit (CP1) further includes second means (GI$_2$) for imposing, on the image transistor (Q2), an emitter current (I2), the value of which corresponds to the difference (I2 = It-I1) between a total current (It) imposed by the current generator (GI$_1$) and the emitter bias current (I1) of the follower transistor (Q2).

6. Amplifier device according to one of the preceding claims, characterized in that the emitter bias current (I1) and the image current (I2) have the same value.

7. Amplifier device according to one of the preceding claims, characterized in that it includes a third and a fourth transistor (Q3, Q4) mounted in common-collector mode, the bases (B3, B4) of which are linked to the collector (C2) of the image transistor (Q2), the emitter (E3) of the third transistor (Q3) being linked to the base (B2) of the image transistor (Q2) and the emitter (E4) of the fourth transistor (Q4) being linked to the base (B1) of the follower transistor (Q1).

8. Amplifier device according to Claim 7, characterized in that the image transistor (Q2) and the third and fourth transistor (Q3, Q4) are of the same type (NPN) as the follower transistor (Q1).

9. Amplifier device according to either of Claims 7 and 8, characterized in that the third and the fourth transistor (Q3, Q4) are paired.

10. Amplifier device according to any one of Claims 7 and 8 and 9, characterized in that the follower transistor (Q1), the image transistor (Q2) and the third and fourth transistor (Q3, Q4) are all of the NPN type.

11. Amplifier device according to one of the preceding claims, characterized in that the bias circuit (CP1) further includes a circuit of the "Wilson mirror" (WM) type.

12. Amplifier device according to any one of Claims 5 to 10, characterized in that the bias circuit (CP1) includes a circuit of the "Wilson mirror" (WM) type, with the aid of which the image transistor (Q2) is linked to the second means (GI$_2$) for imposing an emitter current (I2).

13. Amplifier device according to any one of Claims 5 to 12, characterized in that the second means (GI$_2$) for imposing an emitter current on the image transistor (Q2) consist of an active load.

EP 0 556 077 B1

# FIG.1

# FIG.2

# FIG.3

8

FIG.4

FIG.5